# EUROPÄISCHE PATENTSCHRIFT

(11) **EP 2 888 746 B1**
(45) Veröffentlichungstag und Bekanntmachung des Hinweises auf die Patenterteilung: **09.01.2019**
(21) Anmeldenummer: 13750507.9
(22) Anmeldetag: 09.08.2013
(51) Int. Cl.: H01F 27/28, H05K 1/16

(54) **PLANARER ÜBERTRAGER**
PLANAR TRANSMITTER
TRANSFORMATEUR PLAN

(30) Priorität: 22.08.2012 DE 102012016569
(43) Veröffentlichungstag der Anmeldung: 01.07.2015
(73) Patentinhaber: Phoenix Contact GmbH & Co. KG, 32825 Blomberg (DE)
(72) Erfinder: SCHOLZ, Peter, 32683 Barntrup (DE)
(74) Vertreter: Bill, Burkart Hartmut
(86) Internationale Anmeldenummer: PCT/EP2013/002399
(87) Internationale Veröffentlichungsnummer: WO 2014/029472

(56) Entgegenhaltungen:
- WO-A1-2011/047819
- WO-A1-2013/124049
- DE-A1-102007 019 111
- DE-A1-102009 057 788
- US-A1- 2010 188 872
- US-A1- 2011 133 561

## Beschreibung

Die Erfindung betrifft einen planaren Übertrager.

Die vorliegende Erfindung bezieht sich allgemein auf das Gebiet der Schnittstellentechnik oder Interfacetechnik mit elektronischen Bauelementen, die für Mess-, Steuer- und Regelungsaufgaben, insbesondere als Trennverstärker, eingesetzt werden können. Diese Trennverstärker stellen eine galvanische Trennung zwischen einem Primärkreis und einem Sekundärkreis bereit.

Übertrager oder Transformatoren werden zur galvanischen Trennung von Stromkreisen nach verschiedenen Normen eingesetzt, wobei über die Übertrager sowohl Energie als auch Signale und/oder Daten übertragen werden können,

WO 2011/047819 A1 D1 betrifft eine induktive elektronische Baugruppe zum Ausbilden einer Anordnung mit einer möglichst geringen Anzahl von Kernelementen, wobei drei Schenkel vorgeschlagen werden, mit denen mindestens zwei voneinander unabhängige Transformatoren ausgebildet werden können. Hierbei wird eine magnetische Kopplung zwischen einer ersten Wicklung und einer zweiten Wicklung bereitstellt, wobei jede dieser Wicklungen einen Transformator bereitstellt, ohne dass der durch die erste Wicklung gebildete Transformator magnetisch den Transformator der zweiten Wicklung beeinflusst. Hierzu wird die erste Wicklung als Reihenschaltung von zwei Teilwicklungen vorgesehen und ein durch die erste Wicklung bewirkter Fluss hebt sich auf, so dass die zweite Wicklung magnetisch nicht beeinflusst wird. Hierbei kann die vorgeschlagene Schaltungsanordnung planar mittels Leiterbahnen ausgeführt sein.

US 2010/188872 A1 beschreibt eine Schaltungsanordnung mit einem Transformator, der als Puls-Transformator ausgebildet ist, um Pulssignale zur Ansteuerung eines Schalters zu übertragen.

US 2011/133561 A1 beschreibt eine Halbleiteranordnung mit einem Hauptsubstrat, das ein ferromagnetisches Material aufweist, und mit einem ersten Halbleiterchip und einem zweiten Halbleiterchip, die auf dem Hauptsubstrat angeordnet sind. Hierbei ist eine erste Spule auf dem Hauptsubstrat angeordnet und elektrisch mit dem ersten Halbleiterchip verbunden. Ferner ist eine zweite Spule auf der ersten Spule angeordnet und elektromagnetisch mit der ersten Spule gekoppelt und auch elektrisch mit dem zweiten Halbleiterchip verbunden.

DE 10 2009 057788 A1 beschreibt einen Planartransformator mit einer ersten Platine und einer zweiten Platine, wobei der Planartransformator für einen eigensicheren Betrieb geeignet ist, indem mindestens ein Trennabstand oder eine Luft- und Kriechstrecke asymmetrisch auf die erste und die zweite Platine aufgeteilt ist.

02 10 2007 019111 A1 beschreibt einen Planartransformator mit einer Hauptleiterplatte und einer Sekundärleiterplatte, wobei die Hauptleiterplatte und die Sekundärleiterplatte mit als Leiterbahnen ausgeführte Wicklungen versehen und im Bereich eines Kerns angeordnet sind,

Es sind planare Übertrager bekannt, bei denen einzelne Wicklungen des Übertragers im Wesentlichen in einer Ebene nebeneinander angeordnet sind. Dies ermöglicht eine flache Bauform, so dass der Übertrager beispielsweise in Geräte mit geringer Bauhöhe integriert werden kann. Ein solcher planarer Übertrager ist beispielsweise in der nach dem Anmeldedatum der vorliegenden Anmeldung veröffentlichten Anmeldung WO2013124049 A1 offenbart.

Es wäre wünschenswert noch weiter die vorgegebenen geometrischen Abmessungen eines solchen Übertragers nutzen zu können. Es ist eine Aufgabe der vorliegenden Erfindung, Miniaturisierungsmöglichkeiten von planaren Übertragern vorzuschlagen.

Die Aufgabe wird mit einem planaren Übertrager gemäß Anspruch 1 gelöst.

Auf diese Weise können bei einem planaren Übertrager bei unverändertem Raumbedarf mehr galvanisch getrennte Stromkreise untergebracht werden, ohne dass sich an den grundsätzlichen Funktionen und Vorteilen des Übertrages Änderungen oder Einschränkungen ergeben. Die zusätzlichen Stromkreise können ober- oder unterhalb bereits bestehender Stromkreise angebracht werden und sind aus Funktionssicht von allen anderen Stromkreisen galvanisch getrennt.

Es kann auf diese Weise ein teilweise oder vollständig eigensicherer Übertrager bereitgestellt werden. Als eigensicherer Übertrager wird ein nicht störanfälliger Übertrager bezeichnet, der für eigensichere Stromkreise geeignet ist. Eigensichere Übertrager oder Transformatoren werden zur galvanischen Trennung von Stromkreisen nach verschiedenen Normen eingesetzt, wobei über die Übertrager sowohl Energie als auch Signale und/oder Daten übertragen werden können.

Durch die schichtweise Übereinanderanordnung mit anderen Stromkreisen können zwar Fälle auftreten, bei denen nicht alle Stromkreise nach DIN EN 60079-11 sicher galvanisch voneinander getrennt sind. Dies kann insbesondere die übereinander angeordneten Stromkreise betreffen. Eine sichere galvanische Trennung aller nebeneinander angeordneten Stromkreise kann jedoch vorhanden bleiben.

Bei dieser Vorgehensweise ergibt sich ein gemischter Übertrager, der zu Teilen eigensicher sein kann, beispielsweise in Bezug auf nebeneinander liegende Stromkreise, und zum Teil galvanische Funktionstrennungen aufweist, beispielsweise in Bezug auf übereinander liegende Stromkreise. Dabei soll nicht ausgeschlossen sein, dass die galvanische Trennung auch eigensicheren Aspekten genügen kann.

Der erste Stromkreis oder der zweite Stromkreis kann jeweils in eine Mehrzahl oder Vielzahl von galvanisch voneinander getrennten oder Stromkreisen unterteilt sein. Dies bedeutet, dass ein Stromkreis eine Einheit bildet, wobei dieser Stromkreis mehrere voneinander getrennte weitere Stromkreise aufweist. Jeder galvanisch getrennte Stromkreis kann beispielsweise am Übertrager von außen kontaktiert werden. Es kann beispielsweise vorgesehen sein, dass die ersten Stromkreise an einem ersten Schenkel des Übertragers angeordnet sind, während zweite Stromkreise an einem zweiten Schenkel des Übertragers angeordnet sind.

Hierbei liegen beispielsweise alle ersten Stromkreise und alle zweiten Stromkreise im Wesentlichen in einer horizontalen Ebene relativ zueinander, wobei die ersten Stromkreise jeweils übereinander in vertikaler Richtung angeordnet sind. Auch die zweiten Stromkreise können jeweils übereinander in vertikaler Richtung angeordnet sein.

Gemäß einem Ausführungsbeispiel kann vorgesehen werden, dass der Übertrager in eine Hauptleiterplatte integriert ist. Auf diese Weise muss der Übertrager nicht als eigenes Bauelement gefertigt werden sondern wird bei der Herstellung der Leiterplatte miterzeugt.

Gemäß einem Ausführungsbeispiel kann vorgesehen werden, dass der Übertrager als ein eigenes Bauteil ausgeführt ist. Dies ist dann besonders vorteilhaft, wenn der Übertrager mehr Lagen erfordert als für eine Leiterplatte vorgesehen ist, auf dem der Übertrager bereitgestellt werden soll.

Gemäß einem Ausführungsbeispiel kann vorgesehen werden, dass der Übertrager auf einer Hilfsleiterplatte ausgebildet ist. Eine Hilfsleiterplatte kann unabhängig von einer Hauptleiterplatte hergestellt und geprüft werden, so dass Fehler in der Fertigung frühzeitig ausgeschlossen werden können.

Gemäß einem Ausführungsbeispiel kann vorgesehen werden, dass die Hilfsleiterplatte auf einer Hauptleiterplatte anordenbar ist. Hierbei kann durch beispielsweise Steckkontaktierung eine kostengünstige Verbindung zwischen der Hilfsleiterplatte und der Leiterplatte hergestellt werden.

Gemäß einem Ausführungsbeispiel kann vorgesehen werden, dass eine Leiterplatte als Träger ausgebildet ist, auf dem Bahnen und/oder Windungen und/oder Drähte angeordnet sind. Dies ermöglicht auch eine Kombination verschiedener Fertigungstechnologien, wie beispielsweise, Ätztechnik und Wickeltechnik.

Gemäß einem Ausführungsbeispiel kann vorgesehen werden, dass mindestens ein Stromkreis einen oder mehrere Mittelabgriffe aufweisen. Ein Mittelabgriff kann ein Zwischenpotential aufweisen, das für symmetrische oder asymmetrische Schaltungen verwendet werden kann.

Gemäß einem Ausführungsbeispiel kann vorgesehen werden, dass der Übertrager mehrere Kerne aufweist. Mehrere Kerne können miteinander so kombiniert werden, dass der Übertrager beispielsweise in seiner horizontalen Geometrie baukastenähnlich erweitert werden kann.

Gemäß einem Ausführungsbeispiel kann vorgesehen werden, dass einzelne oder mehrere Stromkreise mehrere Kerne zumindest teilweise umschließen. Ein Stromkreis über mehrere Kerne kann eine Primärwicklung bereitstellen, die gleichzeitig in mehrere Sekundärwicklungen einkoppelt.

Gemäß einem Ausführungsbeispiel kann vorgesehen werden, dass ein Mindestabstand zwischen dem ersten Stromkreis und einem zweiten Stromkreis eine eigensichere galvanische Trennung bereitstellt. Hierbei kann vorgesehen sein, dass ein oder mehrere eigensichere Stromkreise beispielsweise horizontal nebeneinander angeordnet werden können und jeweils in der Höhe, d.h. in vertikaler Ausdehnung, wiederum in mehrere galvanisch getrennte Stromkreise unterteilt werden können. Es wird somit ein Übertrager bereitgestellt, insbesondere ein planarer, nicht störanfälliger Übertrager, der für eigensichere Stromkreise geeignet ist und als planarer eigensicherer Übertrager bezeichnet werden kann.

Die galvanisch getrennten Stromkreise als Erweiterung eines ersten, zweiten oder dritten Stromkreises können auf unterschiedlichen Lagen einer Leiterplatte, beispielsweise in vertikaler Richtung übereinander liegen. Um die Bauhöhe der Übertrager nicht oder nur unwesentlich zu vergrößern, kann der Lagenabstand der übereinander liegenden Stromkreise gering sein, so dass nur eine galvanische Funktionstrennung erfolgt, eventuell nicht aber die Trennung nach eigensicheren Gesichtspunkten (nach DIN EN 60079-11). Es sei angemerkt, dass durch dieses Vorgehen die eigensichere galvanische Trennung der seitlich nebeneinander liegenden Stromkreise nicht gefährdet wird.

In verschiedenen Vorschriften und Normen, beispielsweise DIN EN 60079-11, sind für verschiedene Sicherheitsklassen von Betriebsmitteln Mindestabstände für die Trennung der Stromkreise und somit auch der Windungen oder Wicklungen der Transformatoren vorgegeben. Diese Mindestabstände sind vom Isoliermedium abhängig, so dass die Mindestabstände in Feststoffisolierung, Luft- und Kriechstrecken unterteilt sind. In einer typischen Isolationsklasse, beispielsweise Schutzniveau 375 V, beträgt der minimale Trennabstand bei fester Isolierung beispielsweise 1 mm, die Kriechstrecke in Luft 10 mm und die Kriechstrecke unter einer Schutzschicht etwa 3,3 mm.

Eigensichere Übertrager sind hinsichtlich der Geometrie derart ausgelegt und optimiert, dass die benötigten Trennabstände für ein bestimmtes Schutzniveau sichergestellt werden. Dies kann sowohl durch gewickelte Spulen als auch durch gedruckte oder geätzte Spulen auf Leiterplatten gewährleistet werden. Dabei ist bei gedruckten oder geätzten Spulen von Vorteil, dass keine zusätzlichen Wicklungsprozesse benötigt werden und eine gute Reproduzierbarkeit gewährleistet werden kann. Weitere Vorteile können in einer verbesserten thermischen Eigenschaft bei gleichem Kernvolumen liegen. Ferner können Herstellungskosten geringer ausfallen.

Einige Ausführungsbeispiele der Erfindung sind in den Zeichnungen rein schematisch dargestellt und werden nachfolgend näher beschrieben. Es zeigen:
- Fig. 1: eine schematische Darstellung eines bekannten Übertragers;
- Fig. 2: eine erste Ausführungsform eines erfindungsgemäßen Übertragers;

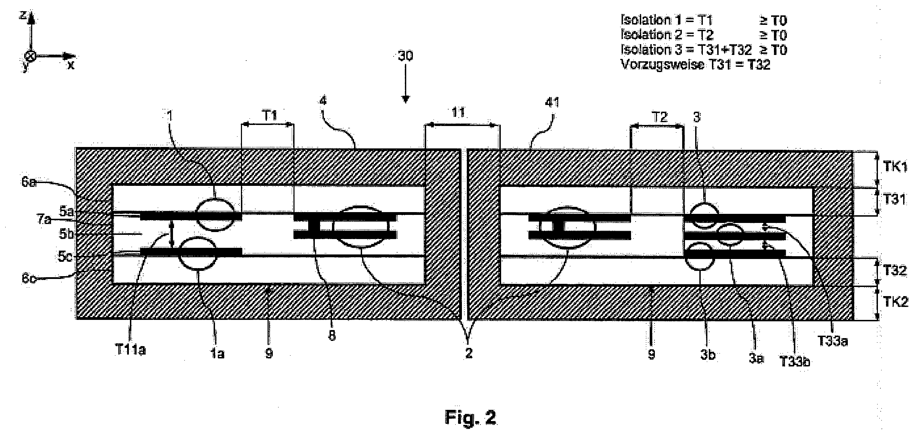

- Fig. 2: eine zweite Ausführungsform eines erfindungsgemäßen Übertrager in der Draufsicht; und

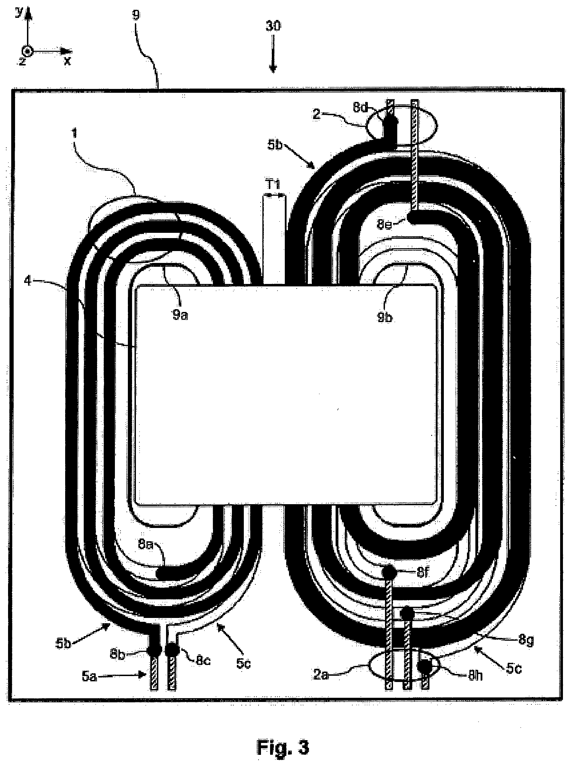

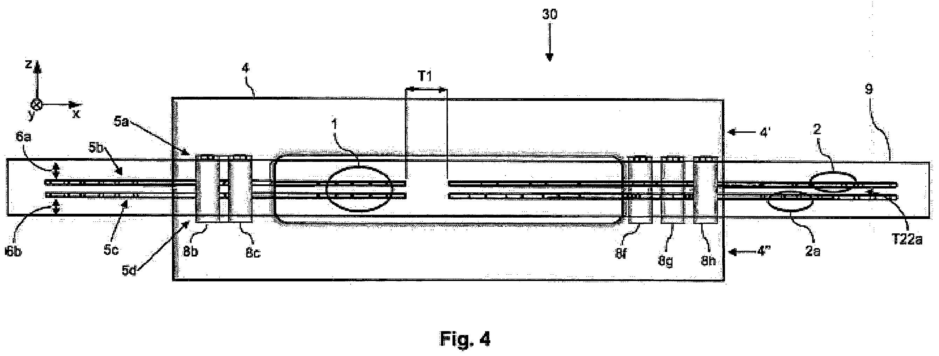

- Fig. 4: den erfindungsgemäßen Übertrager der Fig. 3 in Schnittansicht.

Alle Figuren zeigen schematische nicht maßstabsgerechte Darstellungen. Ähnliche oder identische Elemente werden in den Figuren mit gleichen Bezugszeichen bezeichnet.

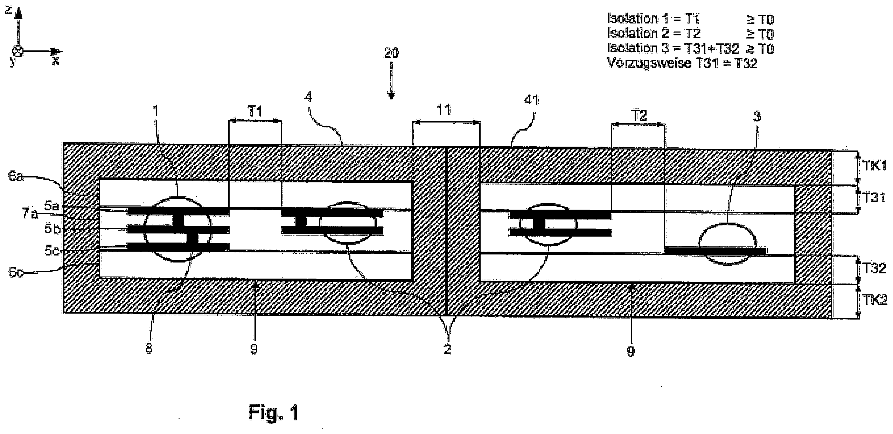

Fig. 1 zeigt eine schematische Darstellung eines bekannten eigensicheren Übertragers 20 mit drei Wicklungen bzw. einem ersten Stromkreis 1, einem zweiten Stromkreis 2 und einem dritten Stromkreis 3, die voneinander galvanisch getrennt und horizontal nebeneinander angeordnet sind. Die erste Wicklung des ersten Stromkreises 1 erstreckt sich über drei Lagen 5a bis 5c eines Leiterplattenaufbaus 9, die zweite Wicklung des zweiten Stromkreises 2 über zwei Lagen 5a und 5b und die dritte Wicklung des dritten Stromkreises 3 über eine Lage 5c.

Die Stromkreise in Fig. 1 sind untereinander durch die Isolationen T1 und T2 galvanisch voneinander getrennt und durch die Isolation T31 und T32 ebenfalls von einem magnetischen Kern 4, 41. Der magnetische Kern ist in diesem Ausführungsbeispiel aus zwei Kernanteilen 4 und 41 gebildet, die nebeneinander angeordnet sind und die Leiterplattenanordnung 9 in dem Bereich 11 durchstoßen. Dabei kann der Stromkreis 2 beispielsweise einen Bereich 11 umschließen und somit mit beiden Kernen 4 und 41 zusammenwirken. Obwohl die einzelnen Windungen bzw. Stromkreise 1, 2, 3 auf unterschiedlichen Lagen 5a bis 5c angebracht werden können, sind sie im Wesentlichen als horizontal nebeneinander zu betrachten, da die Isolationsschichten (Isolation T1, Isolation T2) in die horizontale Dimension ausgebildet sind. Lediglich die dritte Isolation (Isolation T31, T32), die die Stromkreise von den magnetischen Kernen 4, 41 trennt, erstreckt sich durch die beiden Mindestanteile T31 und T32 in die vertikale Dimension. Somit beträgt die Gesamtisolationsdicke auch bei drei sicher galvanisch zu trennenden Stromkreisen 1, 2, 3 nur noch mindestens 1 x T0, wobei T0 die dem Schutzniveau Rechnung getragene Mindestisolationsdicke in isolierendem Medium ist.

In Fig. 1 befinden sich die einzelnen eigensicheren getrennten Stromkreise 1, 2, 3 im Wesentlichen in einer Ebene, die aus den Zwischenlagen 5a, 5b, 5c der Leiterplatte 9 gebildet werden. Die Zwischenlagen 5a, 5b, 5c sind durch isolierende Schichten, hier durch 7a gekennzeichnet, elektrisch voneinander getrennt, können aber durch Kontaktierungen 8 miteinander verbunden werden.

Fig. 2 zeigt eine Ausführungsform eines erfindungsgemäßen Übertragers 30 ausgehend von dem Ausführungsbeispiel der Fig. 1. Hierbei ist in Fig. 2 bei dem erfindungsgemäßen Übertrager 30 der erste Stromkreis 1 um einen weiteren ersten Stromkreis 1a erweitert worden. Der zweite Stromkreis 2 ist gegenüber Fig. 1 unverändert. Zusätzlich ist in Fig. 2 der dritte Stromkreis 3 um zwei weitere dritte Stromkreise 3a und 3b erweitert worden.

In Fig. 2 sind die Stromkreise 1, 2, 3 zueinander eigensicher isoliert. Die einzelnen eigensicheren getrennten Stromkreise 1, 2, 3 befinden sich im Wesentlichen in einer Ebene, die aus den Zwischenlagen 5a, 5b, 5c der Leiterplatte 9 gebildet werden. Die Zwischenlagen 5a, 5b, 5c sind durch isolierende Schichten, hier durch 7a gekennzeichnet, elektrisch voneinander getrennt. Im Gegensatz zu Fig. 1 sind jedoch die Zwischenlagen 5a, 5b, 5c als jeweils getrennte Stromkreise 1, 1a bzw. 3, 3a, 3b ausgeführt. Diese Stromkreise 1, 1a, 3, 3a, 3b werden über eigene Kontaktierungen angeschlossen, die am Übertrager 30 nach außen bereitgestellt werden.

Es erfolgt eine Erweiterung der jeweiligen Stromkreise 1, 2, 3 in der vertikalen Dimension (z-Achse), d.h. die Stromkreise 1, 2, 3 werden jeweils durch darüber oder darunter gelegte Stromkreise 1a, 3a, 3b erweitert, so dass mindestens einer der Stromkreise 1, 2, 3 in eine Mehrzahl von galvanisch voneinander getrennten Stromkreisen 1, 1a, 2, 3, 3a, 3b unterteilt ist.

Durch diese Vorgehensweise können weitere galvanisch getrennte Potentialgruppen bzw. Stromkreise bereitgestellt werden. Gleichzeitig bleibt jedoch die Gesamtdicke des Übertragers 30 gleich und die Ausdehnung in horizontaler Dimension (x-Achse) bleibt ebenfalls bestehen bzw. ändert sich nur geringfügig. Wie bereits in Fig. 2 erkennbar ist, sind durch die erfindungsgemäße Maßnahme die Isolationsabstände zwischen den einzelnen übereinander gelagerten Stromkreisen relativ gering. So ist der Trennabstand T11a zwischen Stromkreis 1 und Stromkreis 1a typischerweise geringer als der Trennabstand T1 zwischen dem Stromkreis 1 und 2, um den strengen Regeln der Eigensicherheit zu genügen. Somit kann es vorkommen, dass die Stromkreise 1 und 1a nach diesen Gesichtspunkten nicht ausreichend voneinander isoliert sind, um einen Eigensicherheitstest zu bestehen. Nach anderen Normen bzw. Anhaltspunkten kann der Trennabstand T11a allerdings durchaus groß genug sein, um gewisse Prüfspannungstests zu bestehen.

Im Gegensatz zu dem ersten Stromkreis 1 ist in Fig. 2 der dritte Stromkreis 3 um zwei Stromkreise 3a und 3b erweitert worden. Diese Stromkreise 3, 3a, 3b liegen übereinander auf den Lagen 5a, 5b, 5c des Leiterplattenaufbaus und sind durch Isolationsabstände T33a bzw. T33b voneinander getrennt. Auch sind die Isolationsabstände T33a bzw. T33b gegenüber dem Abstand T2 typischerweise geringer, so dass sie eventuell keiner eigensicheren Trennung genügen. In einem beispielhaften Lagenaufbau können T33a und T33b jeweils etwa 100 *µ*m betragen, wohingegen T2 beispielsweise 1 mm betragen kann.

Fig. 3 und Fig. 4 zeigen ein weiteres Ausführungsbeispiel der Erfindung in zwei verschiedenen Ansichten. Fig. 3 zeigt einen erfindungsgemäßen Übertrager 30 in der Draufsicht und Fig. 4 zeigt den erfindungsgemäßen Übertrager 30 der Fig. 3 in Schnittansicht.

In Fig. 3 ist der planare Übertrager oder Planarübertrager 30 auf einer Leiterplatte 9 aufgebracht, die die Hauptleiterplatte einer elektronischen Schaltung darstellen kann. So können neben dem Übertrager 30 weitere Elektronikbauteile angebracht werden. Alternativ dazu kann der Übertrager 30 auf einer separaten Leiterplatte angebracht werden, die im Wesentlichen nur den Übertrager 30 aufweist. In diesem Fall können Anschlusskontaktierungen des Übertragers 30 auf den Rand der Leiterplatte 9 geführt werden, um von dort an weitere Elektronik auf der Hauptleiterplatte angeschlossen werden zu können. Die Leiterplatte 9 weist einen Vier-Lagen-Aufbau mit den Lagen 5a bis 5d auf mit zwei Aussparungen 9a und 9b, durch die hindurch der magnetische Kern 4 geführt werden kann.

In Fig. 3 befinden sich einzelne eigensichere getrennte Stromkreise 1 und 2, 2a im Wesentlichen in einer Ebene, die aus den Zwischenlagen 5b, 5c der Leiterplatte 9 gebildet werden. Die Zwischenlagen 5b, 5c sind durch isolierende Schichten elektrisch voneinander getrennt, beispielsweise mit dem Abstand T22a (vgl. Fig. 4). Der erste Stromkreis 1 in Fig. 3 und Fig. 4 ist wie in Fig. 1 ausgeführt, d.h. in zwei Lagen 5b, 5c mit einer Durchkontaktierung 8a, die in Fig. 3 gezeigt ist. Die zweiten Stromkreise 2, 2a hingegen sind voneinander galvanisch getrennt und werden durch eigene Durchkontaktierungen 8d, 8e für Stromkreis 2 und 8h, 8g, 8f für Stromkreis 2a angeschlossen, die am Übertrager 30 auf der Lage 5a nach außen geführt werden. Hierbei sind Durchkontaktierungen elektrische Verbindungen von einer Lage zu einer anderen Lage, die durch beispielsweise Bohrungen auf den Leiterplatten bereitgestellt werden und beispielsweise auf der Innenseite mit elektrisch leitfähigem Material ausgekleidet sind.

Der erste Stromkreis 1 in Fig. 3 ist in diesem Ausführungsbeispiel die Primärwicklung des Übertragers 30 bzw. Transformators, die spiralförmig auf zwei verschiedenen Innenlagen 5b (schwarz gefüllt) und 5c (weiß gefüllt) mit insgesamt sechs Windungen ausgeführt ist. Bei der Durchkontaktierung 8a werden die beiden Lagen 5b, 5c elektrisch miteinander verbunden und bei optionalen Durchkontaktierungen 8b und 8c wird die Gesamtwicklung auf die äußere Lage 5a (gestrichelt dargestellt) geführt. Die Windungen des ersten Stromkreises 1 sind von der Aussparung 9a der Leiterplatte 9 mit einer Mindestisolation von TO/2 entfernt und ragen auch an die Ober- und Unterseite der Leiterplatte 9 nicht näher als TO/2 heran. Dies ist durch den Lagenaufbau sichergestellt, da die Isolationsschichten 6a und 6b eine Mindestdicke von TO/2 aufweisen.

Der erste Stromkreis 1 ist über eine Trennstrecke T1 >= T0 von den weiteren zweiten Stromkreisen 2 und 2a sicher galvanisch getrennt. Diese beiden zweiten Stromkreise 2, 2a können beispielsweise zwei Sekundärwicklungen eines Übertragers 30 darstellen. Die spiralförmigen Windungen der beiden Stromkreise 2 und 2a sind wiederum auf den Innenlagen der Leiterplatte 9 ausgeführt und ragen ebenfalls nicht näher als TO/2 an die Aussparung 9b heran, so dass eine sichere galvanische Trennung zwischen dem ersten Stromkreis 1 und den zweiten Stromkreisen 2, 2a erreicht werden kann.

Erfindungsgemäß sind die beiden zweiten Stromkreise 2 und 2a in Fig. 3 übereinander auf zwei verschiedenen Innenlagen der Leiterplatte 9 angebracht und berühren sich an keinem geometrischen Ort auf der Leiterplatte. So sind die Windungen des Stromkreises 2 auf der Lage 5b der Leiterplatte ausgeführt und über die Kontaktierungen 8d bzw. 8e auf die Anschlussleitungen der Lage 5a verbunden. Demgegenüber sind die spiralförmigen Windungen des Stromkreises 2a auf der Innenlage 5c ausgeführt und werden über die Kontaktierungen 8f, 8g und 8h mit der Anschlusslage 5a verbunden. In diesem Fall ist die Wicklung 2a mit drei Anschlüssen ausgebildet, wobei der mittlere Anschluss in Fig. 3 einen Mittelabgriff ausbilden kann.

Die Windungen der beiden zweiten Stromkreise 2 und 2a in Fig. 3 sind so dimensioniert, dass keine Kurzschlüsse zwischen den beiden Stromkreisen 2 und 2a entstehen. Dies ist insbesondere bei den Durchkontaktierungen zu berücksichtigen. Es verlaufen beispielsweise die drei Windungen des Stromkreises 2 derart um die Durchkontaktierungen 8f und 8g, dass es keine Kurzschlüsse geben kann und dass eine Mindestisolation eingehalten wird.

Durch die beschriebene Maßnahme sind auch die beiden Stromkreise bzw. Wicklungen 2 und 2a galvanisch voneinander getrennt. Bei der Dimensionierung der Trennabstände dieser beiden Stromkreise 2, 2a können andere Maßstäbe herangezogen werden. Es können die Isolationsabstände zwischen den Stromkreisen 2 und 2a beispielsweise so ausgelegt werden, dass sie einer Prüfspannung von beispielsweise 3 kV Gleichspannung standhalten.

Fig. 4 zeigt das Ausführungsbeispiel aus Fig. 3 aus einer seitlichen Perspektive. Die Windungen des ersten Stromkreises 1 sind auf den Lagen 5b und 5c der Leiterplatte 9 angeordnet und durch die Kontaktierungen 8b und 8c mit der oberen Lage 5a und den Anschlüssen der Wicklung des ersten Stromkreises 1 verbunden. Die einzelnen Windungen verlaufen spiralförmig um den linken Schenkel des magnetischen Kerns 4, der in diesem Ausführungsbeispiel der Fig. 4 aus zwei identischen U-Profilen 4' und 4" gebildet ist, die miteinander verklebt oder geklammert werden können. Die einzelnen Kernanteile 4', 4" können auch abgewandelt werden, so kann beispielsweise eine U-Kernhälfte mit einer I-Kernhälfte, d.h. einer geradlinienfömigen Geometrie, zu einer ähnlichen Kerngeometrie 4 geformt werden.

Die zweiten Stromkreise 2 und 2a sind durch eine Isolationsschicht mit der Dicke T22a galvanisch voneinander getrennt und verlaufen um den rechten Schenkel des Kerns 4. Über die Durchkontaktierungen 8d (in Fig. 3 gezeigt) und 8e (in Fig. 3 gezeigt) sowie über die Durchkontaktierungen 8f, 8g, 8h sind die Wicklungen der zweiten Stromkreise 2 und 2a entsprechend der Fig. 3 mit der äußeren Lage 5a und deren Anschlussverbindungen kontaktiert. Die untere äußere leitfähige Lage 5d bleibt in diesem Ausführungsbeispiel ungenutzt.

Die Erfindung ist nicht auf die vorliegenden Ausführungsbeispiele beschränkt, so dass Merkmale eines Ausführungsbeispiels mit Merkmalen eines anderen Ausführungsbeispiels kombiniert werden können.

### Bezugszeichenliste

1, 2, 3 Stromkreis bzw. Potentialgruppe
1a, 2a, 3a, 3b erweiterter Stromkreis
4 magnetischer Kern
4' erster Teil eines magnetischen Kerns
4" zweiter Teil eines magnetischen Kerns
41 magnetischer Kern
5a bis 5g Leiterbahnen / Lagen der Leiterplatte
6a bis 6c Isolationsschicht zwischen den Stromkreisen
7a bis 7b Isolationsschicht innerhalb eines Stromkreises
8, 8a bis 8h elektrische Durchkontaktierung
9 Leiterplatte
9a, 9b Aussparungen
11 Bereich einer Aussparung in einer Leiterplatte
20 Übertrager
30 erfindungsgemäßer Übertrager
T0 Mindestisolation / Schutzniveau / Isolationsdicke
TK1 erste Dicke eines magnetischen Kerns
TK2 zweite Dicke eines magnetischen Kerns
T1 erste Isolationsdicke
T2 zweite Isolationsdicke
T21 Abstand / Isolationsdicke
T22 Abstand / Isolationsdicke
T31 Abstand / Isolationsdicke
T32 Abstand / Isolationsdicke
T11a, T22a, T33a, T33b Isolationsabstand

## Patentansprüche

1. Planarer Übertrager (30) mit einer vertikalen Ausdehnung und einer horizontalen Ausdehnung aufweisend :
einen Schichtaufbau mit mehreren leitfähigen Lagen (5a, 5b, 5c, 5d) und mit einer Mehrzahl von Stromkreisen (1, 2, 3), wobei ein erster Stromkreis (1) und ein zweiter Stromkreis (2) galvanisch voneinander getrennt sind, wobei der erste Stromkreis (1) eine Primärwicklung des Übertragers (30) ist und der zweite Stromkreis (2) eine Sekundärwicklung des Übertragers (30) ist,
mindestens einen magnetischen Kern (4), der zumindest teilweise den Schichtaufbau umschließt und zumindest auf den ersten Stromkreis (1) und auf den zweiten Stromkreis (2) wirkt,
wobei der erste Stromkreis (1) und der zweite Stromkreis (2) im Wesentlichen in einer horizontalen Ebene nebeneinander liegen und eine Schicht des Schichtaufbaus bilden, **dadurch gekennzeichnet, dass**
mindestens der erste Stromkreis (1) oder der zweite Stromkreis (2) in eine Mehrzahl galvanisch voneinander getrennten Stromkreisen (1, 1a, 2, 2a) unterteilt ist, wobei die galvanisch voneinander getrennten Stromkreise (1, 1a, 2, 2a) des ersten Stromkreises (1) bzw. des zweiten Stromkreises (2) in vertikaler Richtung übereinander in verschiedenen Lagen des Schichtaufbaus angeordnet sind.

2. Übertrager nach Anspruch 1, **dadurch gekennzeichnete dass** der Übertrager (30) in eine Hauptleiterplatte integriert ist.

3. Übertrager nach Anspruch 1, **dadurch gekennzeichnet, dass** der Übertrager (30) als ein eigenes Bauteil ausgeführt ist.

4. Übertrager nach Anspruch 3, **dadurch gekennzeichnet, dass** der Übertrager (30) auf einer Hilfsleiterplatte ausgebildet ist,

5. Übertrager nach Anspruch 4, **dadurch gekennzeichnet, dass**
die Hilfsleiterplatte auf einer Hauptleiterplatte anordbar ist.

6. Übertrager nach einem der Ansprüche 1 bis 5, **dadurch gekennzeichnet, dass**
eine Leiterplatte (9) als Träger ausgebildet ist, auf dem Bahnen und/oder Windungen und/oder Drähte angeordnet sind.

7. Übertrager nach einem der Ansprüche 1 bis 6, **dadurch gekennzeichnet, dass**
mindestens ein Stromkreis (1, 2, 3) einen oder mehrere Mittelabgriffe aufweisen.

8. Übertrager nach einem der Ansprüche 1 bis 7, **dadurch gekennzeichnet, dass**
der Übertrager (30) mehrere Kerne (4, 41) aufweist.

9. Übertrager nach Anspruch 8, **dadurch gekennzeichnet, dass**
einzelne oder mehrere Stromkreise (1, 2, 3) mehrere Kerne (4, 41) zumindest teilweise umschließen.

10. Übertrager nach einem der Ansprüche 1 bis 9, **dadurch gekennzeichnet, dass**
ein Mindestabstand (T0) zwischen dem ersten Stromkreis (1) und dem zweiten Stromkreis (2) eine eigensichere galvanische Trennung bereitstellt.

## Claims

1. Planar transmitter (30) having a vertical extent and a horizontal extent having
a layer structure with a plurality of conductive layers (5a, 5b, 5c, 5d) and a plurality of electrical circuits (1, 2, 3), wherein a first electrical circuit (1) and a second electrical circuit (2) are galvanically isolated from one another,
wherein the first electrical circuit (1) is a primary winding of the transmitter (30) and the second electrical circuit (2) is a secondary winding of the transmitter (30),
at least one magnetic core (4), which at least partially surrounds the layer structure and acts at least on the first electrical circuit (1) and on the second electrical circuit (2),
wherein the first electrical circuit (1) and the second electrical circuit (2) lie substantially in one horizontal plane side by side and form one layer of the layer structure,
**characterized in that** at least the first electrical circuit (1) or the second electrical circuit (2) is subdivided into a plurality of electrical circuits (1, 1a, 2, 2a) which are galvanically isolated from one another.
wherein the galvanically isolated electrical circuits (1, 1a, 2, 2a) of the first electrical circuit (1) or of the second electrical circuit (2) are arranged above one another in a vertical direction in different layers of the layer structure.

2. Transmitter as claimed in claim 1, wherein the transmitter (30) is integrated into a main printed circuit board.

3. Transmitter as claimed in claim 1, wherein the transmitter (30) is designed as a dedicated component.

4. Transmitter as claimed in claim 3, wherein the transmitter (30) is formed on an auxiliary printed circuit board.

5. Transmitter as claimed in claim 4, wherein the auxiliary printed circuit board can be arranged on a main printed circuit board.

6. Transmitter as claimed in any of claims 1 to 5, wherein a printed circuit board (9) is designed as a carrier on which tracks and/or turns and/or wires are arranged.

7. Transmitter as claimed in any of claims 1 to 6, wherein at least one electrical circuit (1, 2, 3) has one or more center taps.

8. Transmitter as claimed in any of claims 1 to 7, wherein the transmitter (30) has a plurality of cores (4, 41).

9. Transmitter as claimed in claim 8, wherein individual or a plurality of electrical circuits (1, 2, 3) at least partially surround a plurality of cores (4, 41).

10. Transmitter as claimed in any of claims 1 to 9, wherein a minimum distance (T0) between the first electrical circuit (1) and the second electrical circuit (2) provides intrinsically safe galvanic isolation.

## Revendications

1. Transformateur plan (30) présentant une dimension verticale et une dimension horizontale comprenant :
une structure stratifiée présentant plusieurs couches conductrices (5a, 5b, 5c, 5d) et une pluralité de circuits (1, 2, 3), où un premier circuit (1) et un deuxième circuit (2) sont séparés l'un de l'autre de manière galvanique, où le premier circuit (1) est un enroulement primaire du transformateur (30) et le deuxième circuit (2) est un enroulement secondaire du transformateur (30),
au moins un noyau magnétique (4), qui entoure au moins en partie la structure stratifiée et agit au moins sur le premier circuit (1) et sur le deuxième circuit (2),
dans lequel le premier circuit (1) et le deuxième circuit (2) se situent l'un à côté de l'autre sensiblement dans un plan horizontal et forment une couche de la structure stratifiée,
**caractérisé en ce que** :
au moins le premier circuit (1) ou le deuxième circuit (2) est divisé en une pluralité de circuits (1, 1a, 2, 2a) séparés les uns des autres de manière galvanique, où les circuits (1, 2a, 2, 2a) séparés les uns des autres de manière galvanique du premier circuit (1) ou du deuxième circuit (2) sont agencés les uns au-dessus des autres dans la direction verticale en différentes couches de la structure stratifiée.

2. Transformateur selon la revendication 1, le transformateur (30) étant **caractérisé en ce qu'**il est intégré dans une carte de circuits imprimés principale.

3. Transformateur selon la revendication 1, le transformateur (30) étant **caractérisé en ce qu'**il est réalisé sous la forme d'un élément propre.

4. Transformateur selon la revendication 3, le transformateur (30) étant **caractérisé en ce qu'**il est formé sur une carte de circuits imprimés auxiliaire.

5. Transformateur selon la revendication 4, **caractérisé en ce que** la carte de circuits imprimés auxiliaire peut être agencée sur une carte de circuits imprimés principale.

6. Transformateur selon l'une quelconque des revendications 1 à 5, **caractérisé en ce qu'**une carte de circuits imprimés (9) est réalisée sous la forme d'un support sur lequel sont agencés des tracés et/ou des spires et/ou des fils.

7. Transformateur selon l'une quelconque des revendications 1 à 6, **caractérisé en ce qu'**au moins un circuit (1, 2, 3) présente une ou plusieurs prises médianes.

8. Transformateur selon l'une quelconque des revendications 1 à 7, le transformateur (30) étant **caractérisé en ce qu'**il présente plusieurs noyaux (4, 41).

9. Transformateur selon la revendication 8, **caractérisé en ce que** un seul ou plusieurs circuits (1, 2, 3) entourent au moins en partie plusieurs noyaux (4, 41).

10. Transformateur selon l'une quelconque des revendications 1 à 9, **caractérisé en ce qu'**un écart minimal (T0) entre le premier circuit (1) et le deuxième circuit (2) permet d'obtenir une séparation galvanique à sécurité intrinsèque.
